# EUROPEAN PATENT APPLICATION

(11) **EP 4 729 331 A1**
(43) Date of publication of application: **22.04.2026**
(21) Application number: 25197607.2
(22) Date of filing: 22.08.2025
(51) Int. Cl.: B60L 3/00, B60L 3/04, B60L 58/16, B63H 20/00, B63H 21/17, G01R 31/392

(54) **BATTERY DIAGNOSTIC DEVICE FOR ELECTRIC PROPULSION MACHINE AND SHIP PROPULSION SYSTEM**

(30) Priority: 16.10.2024 JP 2024180497
(71) Applicant: Suzuki Motor Corporation, Shizuoka 432-8611 (JP)
(72) Inventor: KATAOKA, Toshiya, Hamamatsu-shi (JP); ARAKI, Kentaro, Hamamatsu-shi (JP)
(74) Representative: Haseltine Lake Kempner LLP

(57) **Abstract**

A battery diagnostic device (51) for an electric propulsion machine (2). The battery diagnostic device (51) is configured to diagnose a battery (22) configured to supply electric power to a motor (4) for driving a propeller of the electric propulsion machine (2). The battery diagnostic device (51) includes a battery diagnostic processing unit (52) configured to perform a battery diagnosis process of diagnosing the battery (22) by discharging from the battery (22) to the motor (4), in a state where a boat to which the electric propulsion machine (2) is attached is moored, a movement determining unit (53) configured to determine whether the boat has moved, and a discharge control unit (54) configured to stop discharging from the battery (22) to the motor (4) for diagnosing the battery (22), in a case where the movement determining unit (53) determines that the boat has moved during the battery diagnosis process.

## Description

### TECHNICAL FIELD

The present disclosure relates to a battery diagnostic device for an electric propulsion machine that diagnoses a battery that supplies electric power to a motor for driving a propeller of the electric propulsion machine, and to a ship propulsion system that includes an electric propulsion machine, a battery, and a battery diagnostic device for the electric propulsion machine.

### BACKGROUND ART

A battery (secondary battery) is used as a power source for a motor (electric motor) of an electric propulsion machine. A battery deteriorates with use. There are many possible causes for deterioration, including repeated charging and discharging, rapid charging and discharging, overcharging, over-discharging, and effects of ambient temperature. A deteriorated battery has a lower full charge capacity than an initial battery (a new battery).

State of Health (SOH) is used as an indicator of the degree of deterioration of the battery. SOH is a ratio of a full charge capacity of a deteriorated battery to a full charge capacity of an initial battery. The full charge capacity of a deteriorated battery can be found, for example, by bringing the battery to a fully charged state, carrying out a constant current discharge of the battery until a battery voltage reaches a discharge end voltage, and multiplying a current value of the constant current discharge by the time it takes from the start of discharge until the battery voltage reaches the discharge end voltage. Then, the SOH of the deteriorated battery can be calculated using the full charge capacity of the deteriorated battery and the full charge capacity of the initial battery.

Battery deterioration, for example, a decrease in the full charge capacity of the battery, reduces a driving distance per full charge of the battery. Therefore, it is important for a boat operator and other users (hereinafter referred to as "boat operator and the like") of the boat to know a degree of deterioration of the battery.

JP2012-103095A describes a battery management system that analyzes a life span of a battery that supplies electric power to a motor of an electric boat or an electric vehicle.

### SUMMARY OF INVENTION

Meanwhile, there is a demand for an easily implementable battery diagnosis method that allows a boat operator and the like to know a degree of deterioration of the battery and the like.

One easily implementable battery diagnosis method is to diagnose the battery by discharging electric power from the battery to a motor of an electric propulsion machine while the battery is connected to the electric propulsion machine and is diagnosed. This method makes it easier to perform battery diagnosis than a method in which the battery is connected to another load.

When diagnosing the battery by connecting the battery to the electric propulsion machine and discharging from the battery to the motor of the electric propulsion machine, a method of diagnosing the battery during actual navigation can be considered. However, during actual navigation, a rotation speed of the motor of the electric propulsion machine varies in various ways depending on a navigation situation, and a current value of the discharge from the battery to the motor varies in various ways. Therefore, the method of diagnosing the battery during actual navigation results in low accuracy of the battery diagnosis.

In view of the above, it is desirable to perform battery diagnosis while the boat is moored to a pier or the like by connecting the battery to the electric propulsion machine and discharging electric power from the battery to the motor of the electric propulsion machine. As the battery discharges electric power toward the motor, the motor is driven during the battery diagnosis, causing a propeller to rotate and thereby generating a force to propel the boat. However, since the boat is moored to the pier or the like, the boat is not moved by the drive of the motor.

However, during battery diagnosis, for example, against wishes of the boat operator and the like, a rope mooring the boat to the pier or the like may come undone, causing the boat to move due to a propulsive force generated by the drive of the motor, which may result in a hull of the boat coming into direct contact with the pier or the like, or the boat being swept out to sea.

### SUMMARY OF INVENTION

Aspect of non-limiting embodiments of the present disclosure relates to provide a battery diagnostic device for an electric propulsion machine and a ship propulsion system that can suppress movement of a boat when the boat becomes able to move while a battery diagnosis is being performed by discharging from a battery to a motor of the electric propulsion machine while the boat is moored.

Aspects of certain non-limiting embodiments of the present disclosure address the features discussed above and/or other features not described above. However, aspects of the non-limiting embodiments are not required to address the above features, and aspects of the non-limiting embodiments of the present disclosure may not address features described above.

According to an aspect of the present disclosure, there is provided a battery diagnostic device for an electric propulsion machine, the battery diagnostic device being configured to diagnose a battery configured to supply electric power to a motor for driving a propeller of the electric propulsion machine, the battery diagnostic device including:
a battery diagnostic processing unit configured to perform a battery diagnosis process of diagnosing the battery by discharging from the battery to the motor, in a state where a boat to which the electric propulsion machine is attached is moored;
a movement determining unit configured to determine whether the boat has moved; and
a discharge control unit configured to stop discharging from the battery to the motor for diagnosing the battery, in a case where the movement determining unit determines that the boat has moved during the battery diagnosis process.

### BRIEF DESCRIPTION OF DRAWINGS

Exemplary embodiment(s) of the present invention will be described in detail based on the following figures, wherein:
FIG. 1 is a block diagram illustrating a ship propulsion system according to a first example of the present disclosure;
FIG. 2 is an overall view illustrating a boat provided with the ship propulsion system according to the first example of the present disclosure;
FIG. 3 is an explanatory diagram illustrating an electric propulsion machine and a battery device according to the first example of the present disclosure;
FIG. 4 is a block diagram illustrating a battery diagnostic device according to the first example of the present disclosure;
FIG. 5 is a flow chart illustrating a process flow in the battery diagnostic device according to the first example of the present disclosure;
FIG. 6 is a block diagram illustrating a battery diagnostic device according to a second example of the present disclosure;
FIG. 7 is a flow chart illustrating a process flow in the battery diagnostic device according to the second example of the present disclosure;
FIG. 8 is a flow chart illustrating a modification example of the battery diagnostic device according to the first example of the present disclosure; and
FIG. 9 is a block diagram illustrating a modification example of the ship propulsion system according to the first example of the present disclosure.

### DESCRIPTION OF EMBODIMENTS

A battery diagnostic device for an electric propulsion machine according to an embodiment of the present disclosure is a device that diagnoses a battery that supplies electric power to a motor for driving a propeller of the electric propulsion machine. The battery diagnostic device for an electric propulsion machine according to this embodiment includes a battery diagnostic processing unit, a movement determining unit, and a discharge control unit.

The battery diagnostic processing unit performs a battery diagnosis process. The battery diagnosis process is a process for diagnosing the battery by discharging electric power from the battery to the motor while the boat to which the electric propulsion machine is attached is moored. The battery diagnosis performed by the battery diagnostic processing unit is, for example, a diagnosis of the degree of deterioration of the battery. During the battery diagnosis process, electric power is discharged from the battery to the motor, which drives the motor and thus rotates the propeller, thereby generating a force to propel a boat. However, since the battery diagnosis process is performed while the boat is moored, for example, to a pier, the boat will not move due to the motor being driven unless, for example, an incident occurs in which a rope mooring the boat to the pier or the like comes undone or breaks against wishes of a boat operator or the like.

The movement determining unit determines whether the boat has moved. For example, when the incident occurs in which the rope mooring the boat to the pier or the like comes undone or breaks against the wishes of the boat operator and the like, the boat will move due to a propulsive force generated by the drive of the motor. When the boat has moved, the movement determining unit determines that the boat has moved.

The discharge control unit stops discharging from the battery to the motor for diagnosing the battery when the movement determining unit determines that the boat has moved during the battery diagnosis process. When the discharge from the battery to the motor is stopped, the motor stops and no longer generates the force to propel the boat. This prevents the boat from moving due to the motor being driven.

In this way, with the battery diagnostic device for the electric propulsion machine of this embodiment, when an incident occurs during battery diagnosis, such as the rope mooring the boat to the pier or the like coming undone, making the boat able to move, the movement of the boat due to motor drive can be prevented, thereby suppressing the movement of the boat.

Moreover, a ship propulsion system according to an embodiment of the present disclosure includes an electric propulsion machine, a battery, and a battery diagnostic device for the electric propulsion machine. In the ship propulsion system of this embodiment, the electric propulsion machine is attached to a boat and has a motor for driving a propeller. The battery provides electric power to the motor. The battery diagnostic device for the electric propulsion machine diagnoses the battery. Moreover, the battery diagnostic device for the electric propulsion machine in the ship propulsion system of this embodiment has the same configuration as the battery diagnostic device for the electric propulsion machine in the above-described embodiment of the present disclosure. With the ship propulsion system of this embodiment, when an incident occurs during battery diagnosis by the battery diagnostic device for the electric propulsion machine, such as the rope mooring the boat to a pier or the like coming undone, and the boat becomes able to move, it is possible to prevent the boat from moving due to the drive of the motor of the electric propulsion machine, thereby making it possible to suppress the movement of the boat.

### [Example 1]

### Ship Propulsion System

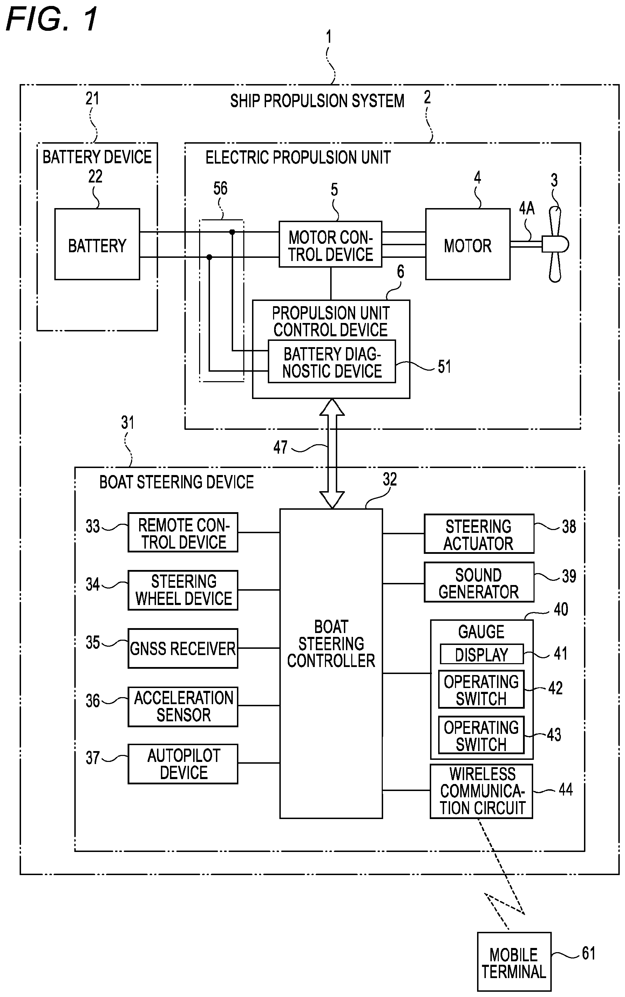

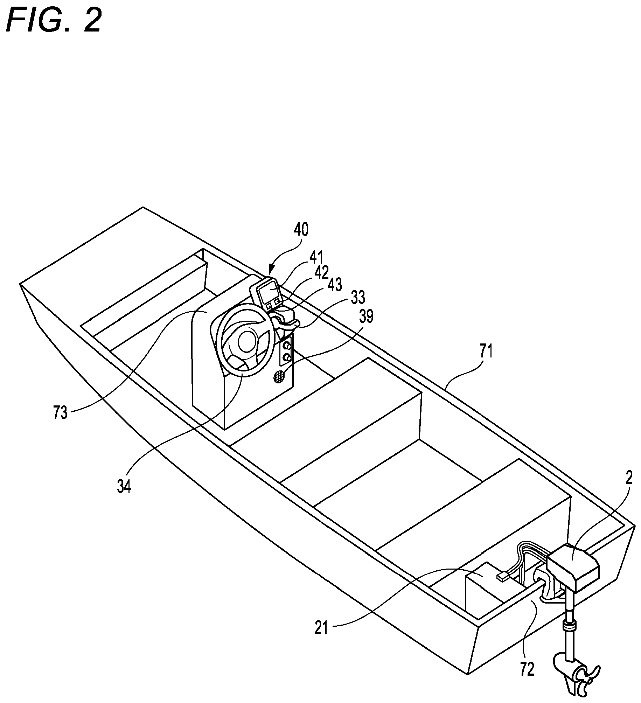

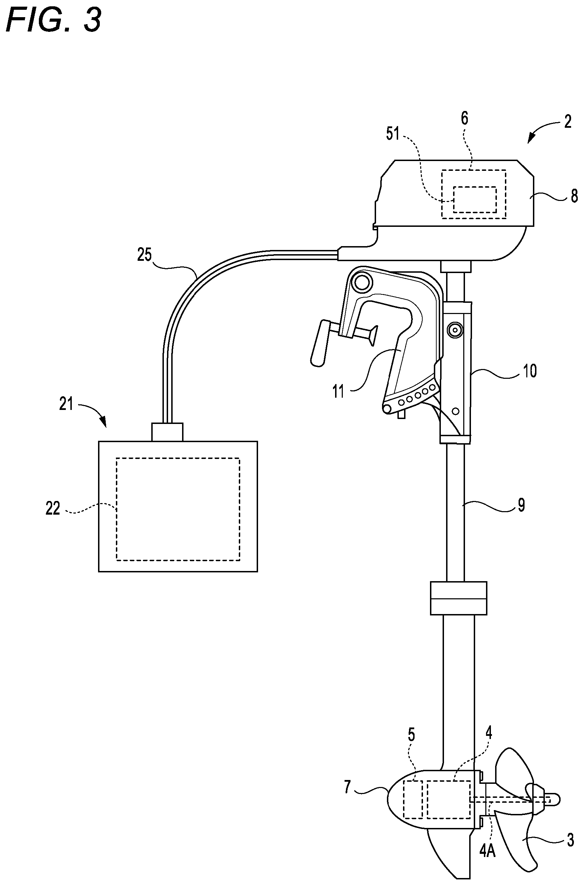

FIG. 1 illustrates configuration of a ship propulsion system 1 according to a first example of the present disclosure. FIG. 2 illustrates a boat 71 provided with the ship propulsion system 1. FIG. 3 illustrates an electric propulsion machine 2 and a battery device 21 in the ship propulsion system 1.

The ship propulsion system 1 is a system configured to propel the boat 71. As illustrated in FIG. 1, the ship propulsion system 1 includes the electric propulsion machine 2, the battery device 21, and a boat steering device 31.

The electric propulsion machine 2 is a device configured to generate a propulsive force for the boat 71 by using a motor 4 as a power source configured to drive a propeller 3. The electric propulsion machine 2 is, for example, an electric outboard motor, and is attached to a transom 72 of the boat 71 as illustrated in FIG. 2.

As illustrated in FIG. 1, the electric propulsion machine 2 includes the propeller 3 configured to generate a propulsive force for the boat, the motor 4 for driving the propeller, a motor control device 5 configured to control the motor 4, and a propulsion unit control device 6 configured to control various devices provided in the electric propulsion machine 2. The motor 4 is, for example, an AC synchronous motor, and the motor control device 5 is, for example, an inverter. The propulsion unit control device 6 has electronic circuits having a calculation function, an information storage function, a Controller Area Network (CAN) communication function, and the like. In addition, the propulsion unit control device 6 is configured to control the motor control device 5. The propulsion unit control device 6 is also provided with a battery diagnostic device 51, which will be described below.

As illustrated in FIG. 3, the motor 4 and the motor control device 5 are provided in a housing 7 that is disposed in a lower portion of the electric propulsion machine 2, and the propeller 3 is connected to an output shaft 4A of the motor 4. The propulsion unit control device 6 is provided in a housing 8 that is disposed in an upper portion of the electric propulsion machine 2. The electric propulsion machine 2 also includes a shaft 9 that connects the housing 7 and the housing 8, a swivel bracket 10 that pivotably supports the shaft 9, and a clamp bracket 11 that is connected to the swivel bracket 10 and attaches the electric propulsion machine 2 to the boat 71.

As illustrated in FIG. 1, the battery device 21 includes a battery 22 configured to supply electric power to the motor 4. The battery 22 is, for example, a lithium ion battery. Although not illustrated, the battery device 21 also includes a battery protection circuit that protects the battery 22. The battery protection circuit includes a circuit for preventing the battery 22 from being overcharged or overdischarged. As illustrated in FIG. 2, the battery device 21 is installed on the boat 71. As illustrated in FIG. 3, the battery device 21 is connected to the electric propulsion machine 2 via a cable 25. More specifically, as illustrated in FIG. 1, the battery 22 of the battery device 21 is connected to the motor control device 5 of the electric propulsion machine 2.

The boat steering device 31 is a device configured to operate and control the boat 71. Here, devices, circuits, and the likes related to the operation and control of the boat 71 that are provided on the boat 71 are collectively referred to as the boat steering device 31. Specifically, the boat steering device 31 has a boat steering controller 32 as illustrated in FIG. 1. Furthermore, the boat steering device 31 has a remote control device 33, a steering wheel device 34, a Global Navigation Satellite System (GNSS) receiver 35, an acceleration sensor 36, an autopilot device 37, a steering actuator 38, a sound generator 39, a gauge 40, and a wireless communication circuit 44, and these devices and circuits are each connected to the boat steering controller 32.

The boat steering controller 32 has electronic circuits having a calculation function, an information storage function, a CAN communication function, and the like. The remote control device 33 is a device configured to change the rotation direction and rotation speed of the propeller 3 of the electric propulsion machine 2 in accordance with an operation of a boat operator, thereby switching between forward and reverse travel of the boat 71, and changing and adjusting the boat speed. The steering wheel device 34 and the steering actuator 38 are devices configured to change the direction of the propeller 3 of the electric propulsion machine 2 in accordance with the operation of the boat operator, thereby steering the boat 71. The GNSS receiver 35 is a receiver configured to receive radio waves transmitted from GNSS satellites. Based on the radio waves received by the GNSS receiver 35, the current position of the boat 71 and current speed of the boat 71 can be specified. The acceleration sensor 36 is a device configured to detect the acceleration of the boat 71. The autopilot device 37 is a device configured to automatically control the motor 4 of the electric propulsion machine 2 and the steering actuator 38 to automatically steer the boat 71. The sound generator 39 is a device configured to emit a sound to the boat operator and the like, and is, for example, a buzzer. The gauge 40 is basically an instrument configured to measure and displays an operating status of the electric propulsion machine 2, but in this embodiment the gauge 40 is multifunctional and, in addition to functioning as an instrument for the electric propulsion machine 2, has the function of displaying the status of the boat 71, the function of displaying the status of the battery device 21, and the function of selecting an operation mode of the electric propulsion machine 2. The gauge 40 also includes a display 41 configured to display various information such as the operating status of the electric propulsion machine 2, an operation switch 42 configured to allow the boat operator and the like to select the operation mode of the electric propulsion machine 2, and an operation switch 43 configured to allow the boat operator and the like to input an instruction to start a battery diagnosis. The wireless communication circuit 44 is a circuit configured to perform wireless communication between a mobile terminal 61 and the boat steering controller 32. The mobile terminal 61 is, for example, a smartphone, and the mobile terminal 61 is carried by, for example, a boat operator or the like.

As illustrated in FIG. 2, the remote control device 33, the steering wheel device 34, the sound generator 39 and the gauge 40 are installed in a cockpit 73 of the boat 71. The boat steering controller 32, the GNSS receiver 35, the acceleration sensor 36, the autopilot device 37, and the wireless communication circuit 44 are installed, for example, near the cockpit 73 of the boat 71. The steering actuator 38 is attached to, for example, the clamp bracket 11 of the electric propulsion machine 2. In addition, the steering actuator 38 is not illustrated in FIG. 3.

As illustrated in FIG. 1, the boat steering controller 32 of the boat steering device 31 and the propulsion unit control device 6 of the electric propulsion machine 2 are connected to each other by a communication line 47. The boat steering controller 32 and the propulsion unit control device 6 are configured to communicate with each other via the communication line 47 via a CAN. Specifically, the boat steering controller 32 is configured to transmit a control signal for controlling the rotation speed and rotation direction of the propeller 3 (specifically, the rotation speed and rotation direction of the motor 4) to the propulsion unit control device 6 via CAN communication, according to the operation of the remote control device 33 by the boat operator. The boat steering controller 32 is configured to transmit information indicating the current position of the boat 71 or the current speed of the boat 71, which is specified based on the radio waves received by the GNSS receiver 35, to the propulsion unit control device 6 via CAN communication. The boat steering controller 32 is configured to transmit a selection signal for selecting an operation mode of the electric propulsion machine 2 to the propulsion unit control device 6 via CAN communication in accordance with the operation of the operation switch 42 of the gauge 40. Furthermore, the boat steering controller 32 is configured to transmit a command signal instructing the start of a battery diagnosis to the propulsion unit control device 6 via CAN communication in accordance with the operation of the operation switch 43 of the gauge 40. In addition, the propulsion unit control device 6 is configured to transmit a command signal to the boat steering controller 32 via CAN communication, instructing the sound generator 39 to generate a sound. In addition, the propulsion unit control device 6 is configured to transmit, to the boat steering controller 32 via CAN communication, a command signal instructing the display 41 of the gauge 40 to display information. In addition, the propulsion unit control device 6 is configured to transmit a command signal to the boat steering controller 32 by CAN communication, instructing the transmission of information to the mobile terminal 61 via the wireless communication circuit 44. The communication system between the boat steering controller 32 and the propulsion unit control device 6 may be a system other than CAN.

### Configuration of Battery Diagnostic Device

The battery diagnostic device 51 is a device configured to diagnose the degree of deterioration of the battery 22 of the battery device 21. In this example, the battery diagnostic device 51 is incorporated in the propulsion unit control device 6 of the electric propulsion machine 2, as illustrated in FIG. 1. Specifically, the battery diagnostic device 51 has a computer program that is loaded into and executed by a Central Processing Unit (CPU) of the propulsion unit control device 6, causing the propulsion unit control device 6 to function as the battery diagnostic device 51. This computer program is stored in, for example, a non-volatile memory of the propulsion unit control device 6. Furthermore, the battery diagnostic device 51 has a diagnostic circuit 56 for measuring the current flowing from the battery 22 to the motor 4 and the voltage of the battery 22. The battery diagnostic device 51 is an example of a "battery diagnostic device for an electric propulsion machine".

The battery diagnostic device 51 may be configured to include a processor dedicated to the battery diagnostic device, a non-volatile memory dedicated to the battery diagnostic device in which a computer program that realizes the functions of the battery diagnostic device is stored, and the above-described diagnostic circuit, and these may be provided within the housing 8 of the electric propulsion machine 2.

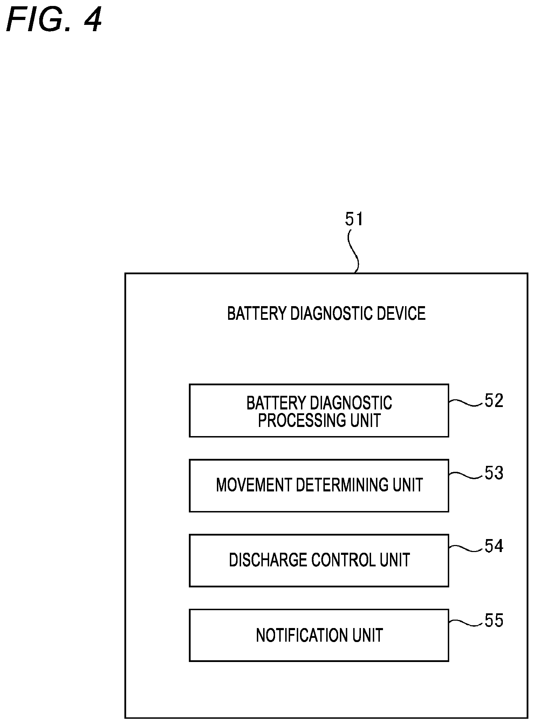

FIG. 4 illustrates configuration of the battery diagnostic device 51 according to the first example of the present disclosure. As illustrated in FIG. 4, the battery diagnostic device 51 includes a battery diagnostic processing unit 52, a movement determining unit 53, a discharge control unit 54, and a notification unit 55. These are implemented by loading into the CPU of the propulsion unit control device 6 a computer program that causes the propulsion unit control device 6 to function as the battery diagnostic device 51 and executing the program (or by loading into a processor dedicated to the battery diagnostic device a computer program that realizes the functions of the battery diagnostic device and executing the program).

The battery diagnostic processing unit 52 is configured to perform a battery diagnosis process. The battery diagnosis process is a process in which, while the boat 71 to which the electric propulsion machine 2 is attached is moored, electric power is discharged from the battery 22 to the motor 4 and the degree of deterioration of the battery 22 is diagnosed.

First, prerequisites for the battery diagnosis process in this example will be described. The battery diagnosis process is performed in a state where the battery 22 is connected to the motor control device 5 of the electric propulsion machine 2. The battery diagnosis process is also performed in a state where the electric propulsion machine 2 is not tilted up, that is, in a state where the propeller 3 is submerged below the water surface. The battery diagnosis process is performed in a case where the battery 22 is in a fully charged state. Furthermore, the battery diagnosis process is performed in a state where the boat 71 is moored to a pier or the like.

Next, the battery diagnosis process in this example will be described. In the battery diagnosis process, the motor 4 is used as a load, and a constant current discharge of the battery 22 at a predetermined current value is carried out. For example, the motor control device 5 is controlled to start discharging from the battery 22 to the motor 4. Then, the diagnostic circuit 56 is used to measure a current value discharging from the battery 22 to the motor 4, and the motor control device 5 is controlled so that the current value becomes the above-mentioned predetermined current value. Then, while measuring the time from the start of discharging, the voltage of the battery 22, which decreases as the battery 22 is discharged, is monitored by the diagnostic circuit 56. Then, when the voltage of the battery 22 reaches the discharge end voltage, the motor control device 5 is controlled to stop discharging from the battery 22 to the motor 4. Thereafter, the predetermined current value is multiplied by the time it takes from the start to the stop of constant current discharge. In this way, a current full charge capacity of the battery 22 is calculated. Next, a current SOH of the battery 22 is calculated by dividing the calculated current full charge capacity of the battery 22 by an initial (new) full charge capacity of the battery 22. The discharge end voltage of the battery 22 and the initial full charge capacity of the battery 22 are stored in advance in a non-volatile memory or the like of the propulsion unit control device 6.

The movement determining unit 53 is configured to determine whether the boat 71 has moved. In this example, the movement determining unit 53 determines that the boat 71 has moved in a case where a distance between the current position of the boat 71 and the position (initial position) of the boat 71 at the start of the battery diagnosis process exceeds a predetermined reference distance, or in a case where the speed of the boat 71 exceeds a predetermined reference speed. In the battery diagnosis process, electric power is discharged from the battery 22 to the motor 4, which drives the motor 4, causing the propeller 3 to rotate and generating a force for propelling the boat 71. However, since the battery diagnosis process is performed while the boat 71 is moored to a pier or the like, the boat 71 will not move due to the driving of the motor 4 during the battery diagnosis process unless an incident occurs, such as, for example, the rope mooring the boat 71 to the pier or the like coming undone or breaking. However, when an incident occurs, for example, when the rope mooring the boat 71 to a pier or the like comes undone or breaks, the boat 71 moves by the driving of the motor 4 during the battery diagnosis process. The movement determining unit 53 has a role of detecting such movement of the boat 71.

When the movement determining unit 53 determines that the boat 71 has moved during the battery diagnosis process, the discharge control unit 54 controls the motor control device 5 to stop discharging from the battery 22 to the motor 4 for diagnosing the battery 22.

The notification unit 55 is configured to notify the movement of the boat 71 during the battery diagnosis process. This notification is made using the sound generator 39, the display 41 of the gauge 40, and the mobile terminal 61, as will be described below.

### Processing in Battery Diagnostic Device

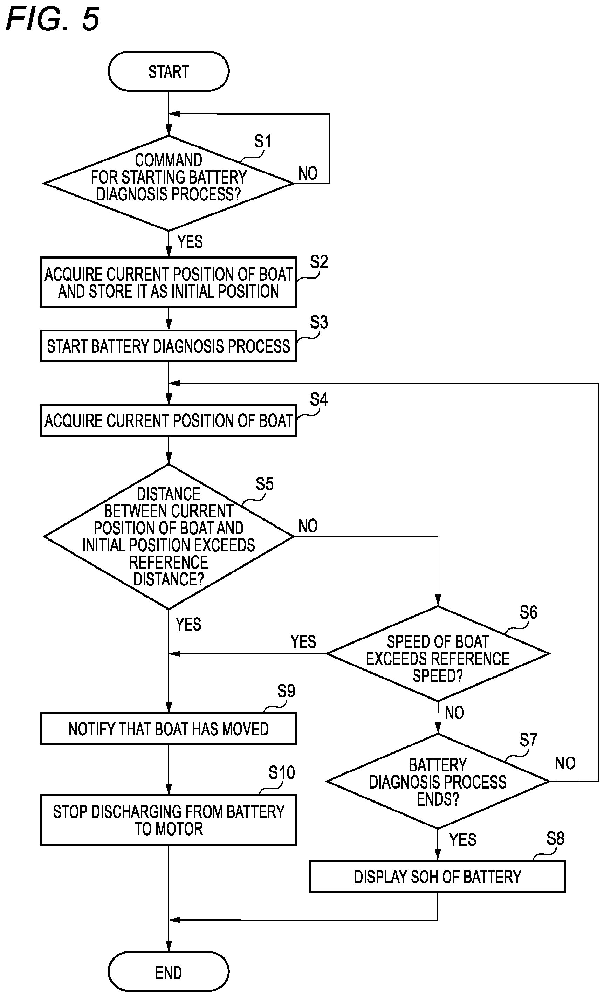

FIG. 5 illustrates a process flow in the battery diagnostic device 51. The process in the battery diagnostic device 51 will be described with reference to FIG. 5.

In preparation for performing a battery diagnosis, the boat operator or the like moors the boat 71 to a pier or the like and connects the battery 22 in a fully charged state to the electric propulsion machine 2. Thereafter, the boat operator or the like operates the operation switch 42 of the gauge 40 to set an operation mode of the electric propulsion machine 2 to a battery diagnosis mode. The operation modes of the electric propulsion machine 2 include a manual operation mode in which the electric propulsion machine 2 is manually operated by the remote control device 33, an autopilot mode in which the electric propulsion machine 2 is automatically operated by the autopilot device 37, and the battery diagnosis mode in which battery diagnosis is performed. The boat operator or the like can select the operation mode of the electric propulsion machine 2 by operating the operation switch 42 of the gauge 40. When the boat operator or the like operates the operation switch 42 of the gauge 40 to change the operation mode of the electric propulsion machine 2 to the battery diagnosis mode, a selection signal indicating that the battery diagnosis mode is selected as the operation mode of the electric propulsion machine 2 is transmitted from the boat steering controller 32 of the boat steering device 31 to the propulsion unit control device 6 of the electric propulsion machine 2. In response to the selection signal, the propulsion unit control device 6 sets the operation mode of the electric propulsion machine 2 to the battery diagnosis mode. When the operation mode of the electric propulsion machine 2 enters the battery diagnosis mode, the propulsion unit control device 6 executes a computer program that causes the propulsion unit control device 6 to function as the battery diagnostic device 51. As a result, the propulsion unit control device 6 functions as a battery diagnostic device 51. Hereinafter, the propulsion unit control device 6 functioning as the battery diagnostic device 51 will be referred to as the battery diagnostic device 51.

Next, when the boat operator or the like operates the operation switch 43 of the gauge 40 to start battery diagnosis, a command signal to start battery diagnosis is transmitted from the boat steering controller 32 of the boat steering device 31 to the battery diagnostic device 51. In response to the command signal, the battery diagnostic device 51 starts the battery diagnosis (step S1 in FIG. 5: YES).

When the battery diagnosis is started, first, the movement determining unit 53 of the battery diagnostic device 51 acquires the current position of the boat 71. Specifically, the movement determining unit 53 requests the boat steering controller 32 to transmit information indicating the current position of the boat 71, and in response to this request, the boat steering controller 32 transmits information indicating the current position of the boat 71, which has been specified based on radio waves received by the GNSS receiver 35, to the battery diagnostic device 51, and the movement determining unit 53 acquires the information indicating the current position of the boat 71. Next, the movement determining unit 53 stores the acquired current position of the boat 71 in the memory of the battery diagnostic device 51 as the initial position of the boat 71 (step S2).

Next, the battery diagnostic processing unit 52 of the battery diagnostic device 51 starts the battery diagnosis process (step S3). Specifically, constant current discharge at a predetermined current value from the battery 22 to the motor 4 of the electric propulsion machine 2, timing of the discharge time, and monitoring of the battery voltage are started. This discharge drives the motor 4, causing the propeller 3 to rotate and generating a force that propels the boat 71. However, since the boat 71 is moored to a pier or the like, the boat 71 will not move due to the driving of the motor 4 unless an incident occurs, such as the rope mooring the boat 71 to the pier or the like coming undone.

Next, the movement determining unit 53 again acquires the current position of the boat 71 (step S4). Next, the movement determining unit 53 compares the acquired current position of the boat 71 with the initial position of the boat 71 stored in the memory of the battery diagnostic device 51 in step S2, and determines whether the distance between the current position of the boat 71 and the initial position of the boat 71 exceeds a predetermined reference distance (step S5).

When the distance between the current position of the boat 71 and the initial position of the boat 71 does not exceed the above-mentioned reference distance (step S5: NO), the movement determining unit 53 then determines whether the current speed of the boat 71 has exceeded a predetermined reference speed (step S6). Specifically, the boat steering controller 32 measures the speed of the boat 71 based on the radio waves received by the GNSS receiver 35. The movement determining unit 53 requests the boat steering controller 32 to transmit information indicating the current speed of the boat 71. In response to this request, the boat steering controller 32 transmits information indicating the current speed of the boat 71 to the battery diagnostic device 51. The movement determining unit 53 acquires the information indicating the current speed of the boat 71, compares the current speed of the boat 71 with the above-mentioned reference speed, and determines whether the current speed of the boat 71 has exceeded the above-mentioned reference speed.

When the current speed of the boat 71 does not exceed the above-mentioned reference speed (step S6: NO), the battery diagnostic device 51 then determines whether the battery diagnosis process has been completed, and when the battery diagnosis process has not been completed (step S7: NO), the process returns to step S4.

When the distance between the current position of the boat 71 and the initial position of the boat 71 does not exceed the above-mentioned reference distance and the speed of the boat 71 does not exceed the above-mentioned reference speed until the battery diagnosis process is completed (step S7: YES), the battery diagnostic device 51 displays the SOH of the battery 22 calculated in the battery diagnosis process, for example, on the display 41 of the gauge 40 (step S8). Specifically, the battery diagnostic device 51 transmits to the boat steering controller 32 the SOH value of the battery 22 calculated in the battery diagnosis process, and a command signal instructing the display 41 of the gauge 40 to display the SOH value. In response to the command signal, the boat steering controller 32 displays the SOH of the battery 22 on the display 41 of the gauge 40.

On the other hand, when the distance between the current position of the boat 71 and the initial position of the boat 71 exceeds the above-mentioned reference distance before the battery diagnosis process is completed (step S5: YES), the process proceeds from step S5 to step S9. Furthermore, when the distance between the current position of the boat 71 and the initial position of the boat 71 does not exceed the above-mentioned reference distance but the speed of the boat 71 exceeds the above-mentioned reference speed before the battery diagnosis process is completed (step S6: YES), the process proceeds from step S6 to step S9. In other words, when an incident occurs during the battery diagnosis process, for example, the rope mooring the boat 71 to a pier or the like comes undone or breaks, the boat 71 will move due to a propulsive force generated by the driving of the motor 4. As a result, the distance between the current position and the initial position of the boat 71 exceeds the reference distance, or the speed of the boat 71 exceeds the reference speed. In that case, the process proceeds to step S9.

Then, in step S9, the notification unit 55 of the battery diagnostic device 51 notifies that the boat 71 has moved. Specifically, the notification unit 55 transmits to the boat steering controller 32 a command signal ordering the sound generator 39 to generate a sound (for example, an alarm sound) indicating that the boat 71 has moved, a command signal ordering the display 41 of the gauge 40 to display that the boat 71 has moved, and a command signal ordering the transmission of a notification that the boat 71 has moved to the mobile terminal 61 via the wireless communication circuit 44. In response to these command signals, the boat steering controller 32 causes the sound generator 39 to generate a sound indicating that the boat 71 has moved, displays on the display 41 of the gauge 40 that the boat 71 has moved, and transmits a notification that the boat 71 has moved to the mobile terminal 61 via the wireless communication circuit 44. In addition, when the mobile terminal 61 receives the notification that the boat 71 has moved, the mobile terminal 61 issues a ringtone, activates a vibrator to vibrate the mobile terminal 61, or displays on the display of the mobile terminal 61 that the boat 71 has moved.

Next, the discharge control unit 54 of the battery diagnostic device 51 stops discharging from the battery 22 to the motor 4 (step S10). When discharging from the battery 22 to the motor 4 is stopped before the battery diagnosis process is completed, the battery diagnosis process is interrupted. Furthermore, the discharge from the battery 22 to the motor 4 is stopped, and the driving of the motor 4 is stopped. This causes the rotation of the propeller 3 driven by the motor 4 to stop, and movement of the boat 71 driven by the motor 4 is prevented.

As described above, with the ship propulsion system 1 or battery diagnostic device 51 of the first example of the present disclosure, when an incident occurs during diagnosis of the battery 22, such as the rope mooring the boat 71 to a pier or the like coming undone, and the boat 71 becomes able to move, the movement of the boat 71 due to the drive of the motor 4 can be prevented, thereby suppressing the movement of the boat 71. Therefore, it is possible to prevent the boat 71 from moving during diagnosis of the battery 22, causing the boat 71 to come into direct contact with a pier or the like, or being swept out to sea. In this manner, the ship propulsion system 1 or the battery diagnostic device 51 of this example allows the boat operator or the like to diagnose the battery 22 easily and safely.

In addition, the battery diagnostic device 51 in the ship propulsion system 1 of this example determines that the boat 71 has moved when the distance between the current position of the boat 71 and the position of the boat 71 at the start of the battery diagnosis process exceeds a predetermined reference distance during the battery diagnosis process, and stops discharging from the battery 22 to the motor 4. This makes it possible to recognize with high accuracy that the boat 71 has moved during the battery diagnosis process. Specifically, a purpose of the battery diagnostic device 51 determining the movement of the boat 71 during the battery diagnosis process is to recognize that an incident has occurred, such as the rope mooring the boat 71 to a pier or the like coming undone, causing the boat 71 to become unmoored, and that the boat 71 in this unmoored state has moved due to the drive of the motor 4. When the diagnosis of the battery 22 is performed, the boat 71 is moored, so even when the motor 4 is driven by discharging electric power from the battery 22 to the motor 4, the boat 71 will not move due to the driving of the motor 4 as long as the boat 71 remains in a moored state. However, even when the boat 71 is moored and prevented from moving by the drive of the motor 4, the boat 71 may move slightly due to wind, waves, or the like. Therefore, in order to recognize with high accuracy that the boat 71 in an unmoored state has moved due to the drive of the motor 4, it is necessary to distinguish between the boat 71 in an unmoored state having moved due to the drive of the motor 4 and the boat 71 in a moored state having moved due to wind, waves, or the like. In this example, the reference distance is set to, for example, the distance that a boat in a moored state moves due to wind, waves, or the like. As a result, by determining that the boat 71 has moved when the distance between the current position of the boat 71 and the position of the boat 71 at the start of the battery diagnosis process exceeds the above-mentioned reference distance, it is possible to distinguish between the boat 71 in an unmoored state having moved due to the drive of the motor 4 and the boat 71 in a moored state having moved due to wind, waves, or the like, and therefore it is possible to recognize with high accuracy that the boat 71 in an unmoored state has moved due to the drive of the motor 4.

In addition, the battery diagnostic device 51 in the ship propulsion system 1 of this example determines that the boat 71 has moved when the speed of the boat 71 exceeds a predetermined reference speed during the battery diagnosis process, and stops discharging from the battery 22 to the motor 4. This makes it possible to recognize with high accuracy that the boat 71 has moved during the battery diagnosis process. To be more specific, as described above, in order to recognize with high accuracy that the boat 71 in an unmoored state has moved due to the drive of the motor 4, it is necessary to distinguish between the boat 71 in an unmoored state having moved due to the drive of the motor 4 and the boat 71 in a moored state having moved due to wind, waves, or the like. The speed of the boat 71 when the boat 71 in an unmoored state moves due to the drive of the motor 4 is faster than the speed of the boat 71 when the boat 71 in a moored state moves due to wind, waves, or the like. In this example, the reference speed is set to, for example, the speed at which a moored boat moves due to wind, waves, or the like. As a result, when the speed of the boat 71 exceeds the above-mentioned reference speed, it is determined that the boat 71 has moved, and it is possible to distinguish between the boat 71 in an unmoored state having moved due to the drive of the motor 4 and the boat 71 in a moored state having moved due to wind, waves, or the like, and therefore it is possible to recognize with high accuracy that the boat 71 in an unmoored state has moved due to the drive of the motor 4.

In addition, during the battery diagnosis process, the battery diagnostic device 51 in the ship propulsion system 1 of this example determines that the boat 71 has moved and stops discharging from the battery 22 to the motor 4 when the speed of the boat 71 exceeds the predetermined reference speed, even when the distance between the current position of the boat 71 and the position of the boat 71 at the start of the battery diagnosis process does not exceed the predetermined reference distance. This makes it possible to further improve the accuracy of recognizing that the boat 71 in an unmoored state has moved due to the driving of the motor 4.

Furthermore, the battery diagnostic device 51 in the ship propulsion system 1 of this example notifies the boat operator or the like of the movement of the boat 71 during the battery diagnosis process. This allows the boat operator or the like to quickly recognize that the boat 71 is no longer moored. Therefore, the boat operator or the like can quickly take measures to ensure the safety of the boat 71 or the like.

In addition, the battery diagnostic device 51 of this example notifies of the movement of the boat 71 during the battery diagnosis process by generating a sound from the sound generator 39 and by displaying on the display 41 of the gauge 40 an indication that the boat 71 has moved. This allows the boat operator or the like on board the boat 71 to be aware of the movement of the boat 71. In addition, the battery diagnostic device 51 notifies the movement of the boat 71 during the battery diagnosis process by transmitting a notification to the mobile terminal 61 carried by the boat operator or the like. This allows the boat operator or the like who has disembarked from the boat 71 and is in a location distant from the boat 71 to be aware of the movement of the boat 71.

### [Example 2]

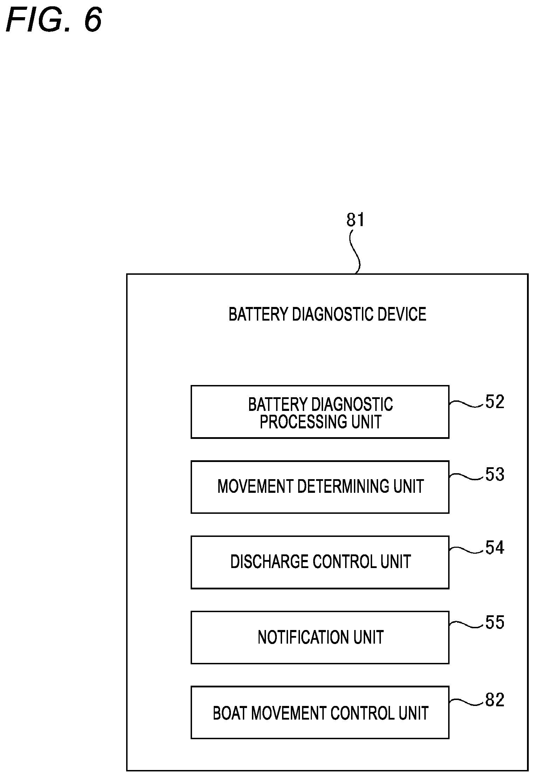

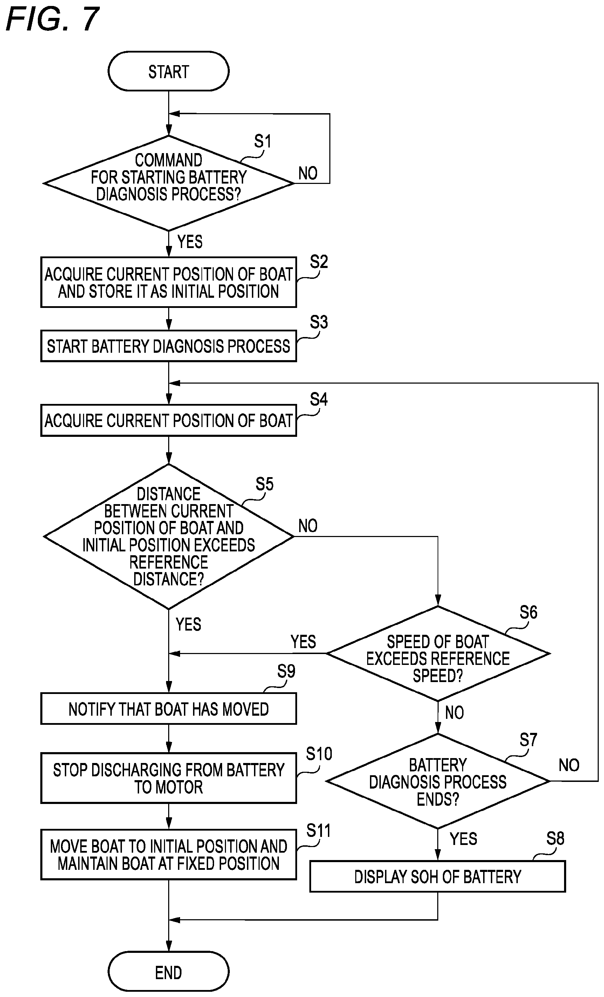

FIG. 6 illustrates a configuration of a battery diagnostic device 81 of a ship propulsion system according to a second example of the present disclosure. FIG. 7 illustrates a process flow in the battery diagnostic device 81.

As illustrated in FIG. 6, the battery diagnostic device 81 in the second example of the present disclosure has a configuration in which a boat movement control unit 82 is added to the battery diagnostic device 51 in the first example of the present disclosure. Except for this point, the configuration of the ship propulsion system and the configuration of the battery diagnostic device 81 of the second example are the same as the configuration of the ship propulsion system 1 and the configuration of the battery diagnostic device 51 of the first example.

As illustrated in step S11 in FIG. 7, after discharging from the battery 22 to the motor 4 for diagnosing the battery 22 is stopped, the boat movement control unit 82 controls the motor 4 to move the boat 71 to a position (initial position) at the start of the battery diagnosis process, and then maintains the boat 71 at the fixed position. Specifically, in step S11, the boat movement control unit 82 transmits a command signal to move the boat 71 to the position at the start of the battery diagnosis process and then maintain the boat 71 at the fixed position, and information indicating the initial position, to the boat steering controller 32. These command signals and the like are transmitted from the battery diagnostic device 51 (the propulsion unit control device 6 functioning as the battery diagnostic device 51) to the boat steering controller 32 via CAN communication. The boat steering controller 32 that receives the command signal or the like switches the operation mode of the electric propulsion machine 2 to the autopilot mode. Next, the boat steering controller 32 sends the command signal and the like to the autopilot device 37 (see FIG. 1). The autopilot device 37, upon receiving the command signal or the like, controls the motor 4 of the electric propulsion machine 2 and the steering actuator 38 to move the boat 71 to the position (initial position) at the start of the battery diagnosis process and then maintain the boat 71 in the fixed position.

With the ship propulsion system or battery diagnostic device 81 of the second example of the present disclosure having such a configuration, when an incident occurs during diagnosis of the battery 22, such as the rope mooring the boat 71 to a pier or the like coming undone and the boat 71 moves, the boat 71 can be quickly returned to the position at the start of the battery diagnosis process and maintained in that position. Therefore, it is possible to prevent the boat 71 from coming into direct contact with a pier or the like, or from being swept out to sea while the battery 22 is being diagnosed. Furthermore, according to this example, not only can the boat 71 that has moved by the driving of the motor 4 through discharging from the battery 22 to the motor 4 be returned to the position at the start of the battery diagnosis process, but it can also prevent the boat 71, which is no longer moored, from moving due to wind, waves, or the like to a position away from the position at the start of the battery diagnosis process. Therefore, the safety of the diagnosis of the battery 22 can be further improved.

**In** addition, the battery diagnostic device 51 (81) in each of the above examples determines that the boat 71 has moved when the speed of the boat 71 exceeds a predetermined reference speed, even when the distance between the current position of the boat 71 and the position of the boat 71 at the start of the battery diagnosis process does not exceed a predetermined reference distance. However, the present disclosure is not limited to this. Whether the boat 71 has moved may be determined solely based on whether the distance between the current position of the boat 71 and the position of the boat 71 at the start of the battery diagnosis process exceeds a predetermined reference distance, and whether the boat 71 has moved may be determined solely based on whether the speed of the boat 71 has exceeded a predetermined reference speed. Alternatively, it may be determined that the boat 71 has moved when the distance between the current position of the boat 71 and the position of the boat 71 at the start of the battery diagnosis process exceeds a predetermined reference distance and when the speed of the boat 71 exceeds a predetermined reference speed.

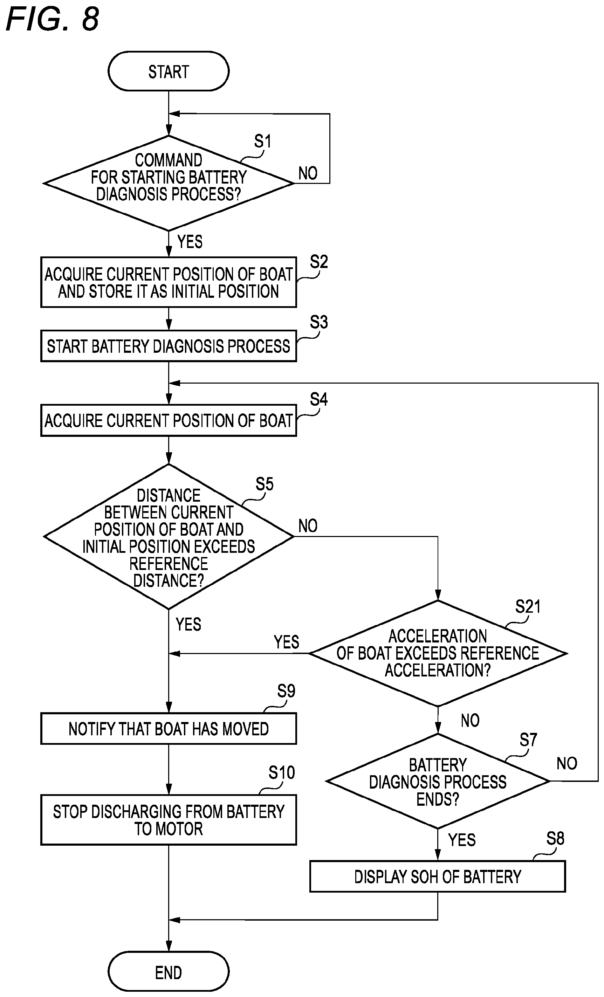

Furthermore, the battery diagnostic device 51 of the first example determines that the boat 71 has moved when the speed of the boat 71 exceeds a predetermined reference speed (see step S6 in FIG. 5). However, the present disclosure is not limited to this. As illustrated in step S21 in FIG. 8, when the acceleration of the boat 71 exceeds a predetermined reference acceleration, it may be determined that the boat 71 has moved. **In** this case, the acceleration of the boat 71 is detected by the acceleration sensor 36. Such modifications can also be made to the battery diagnostic device 81 of the second example.

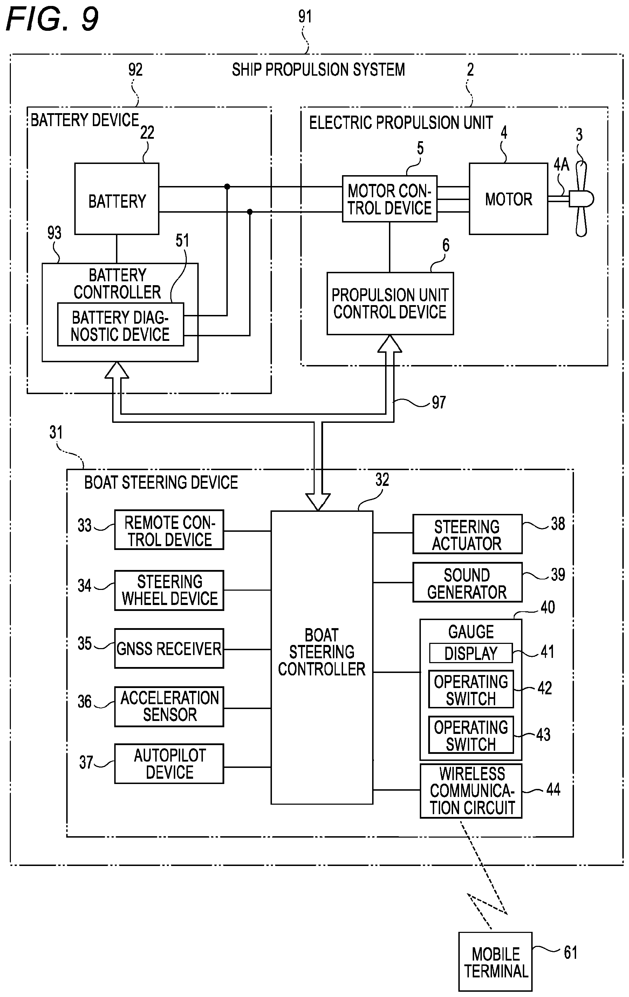

Furthermore, in the ship propulsion system 1 of the first example, the battery diagnostic device 51 is provided in the electric propulsion machine 2. However, the present disclosure is not limited to this. As in a ship propulsion system 91 illustrated in FIG. 9, the battery diagnostic device 51 may be provided in a battery device 92. Specifically, the battery device 92 includes a battery controller 93 including, for example, a battery protection circuit that prevents the battery 22 from being overcharged or overdischarged. The battery controller 93 is connected to the boat steering controller 32 and the propulsion unit control device 6 via a communication line 97, and can communicate with the boat steering controller 32 and the propulsion unit control device 6 via CAN. The battery controller 93 may be provided with the battery diagnostic device 51. Such modifications can also be made to the ship propulsion system according to the second example.

Furthermore, a battery diagnostic method used in the battery diagnosis process in the battery diagnostic device of the present disclosure is not limited to the method described in the above example. For the battery diagnosis process in the battery diagnostic device of the present disclosure, another battery diagnostic method for diagnosing the degree of deterioration of a battery by discharging electric power from the battery to a motor may be used. Furthermore, the battery diagnosis process in the battery diagnostic device of the present disclosure is not limited to a process for diagnosing the degree of deterioration of the battery, but may be a process for diagnosing other characteristics of the battery by discharging electric power from the battery to a motor.

In addition, in the ship propulsion system 1 of each of the above examples, an example is given in which the boat 71 is provided with the GNSS receiver 35 used to determine the movement of the boat 71, as well as the sound generator 39, the gauge 40, and the wireless communication circuit 44, and the like used to notify that the boat 71 has moved, but the present disclosure is not limited to this. For example, an electric propulsion machine equipped with a tiller bar handle may be adopted, and a GNSS receiver, a buzzer, a gauge, a wireless communication circuit, and the like may be provided on the tiller bar handle.

Furthermore, in the ship propulsion system 1 of the first example described above, the autopilot device 37 does not need to be provided, and when an electric propulsion machine equipped with a tiller bar handle is used, the steering actuator 38 can be removed.

Furthermore, the satellite positioning system used in the ship propulsion system 1 or the battery diagnostic device 51 (81) of the present disclosure is not limited to the GNSS, and may be, for example, a Global Positioning System (GPS). In addition, means used by the notification unit 55 of the battery diagnostic device 51 (81) to notify of the movement of the boat is not limited to a buzzer and a display, but may be a sound generator such as a speaker or a siren, or an indicator such as a lamp. Furthermore, a party to which the notification unit 55 notifies the movement of the boat using the wireless communication circuit 44 is not limited to the mobile terminal 61, but may be another device with a communication function, such as a personal computer.

Furthermore, the electric propulsion machine in the ship propulsion system of the present disclosure is not limited to an electric outboard motor, but may be an electric ship propulsion unit other than an electric outboard motor, such as an electric inboard-outboard motor.

Furthermore, the present invention can be modified as appropriate within the scope that does not contradict the gist or concept of the invention that can be read from the claims and the entire specification, and the battery diagnostic device for an electric propulsion machine and the ship propulsion system that involve such modifications are also included in the technical concept of the present invention.

## Claims

1. A battery diagnostic device (51) for an electric propulsion machine (2), the battery diagnostic device (51) being configured to diagnose a battery (22) configured to supply electric power to a motor (4) for driving a propeller of the electric propulsion machine (2), the battery diagnostic device (51) comprising:
a battery diagnostic processing unit (52) configured to perform a battery diagnosis process of diagnosing the battery (22) by discharging from the battery (22) to the motor (4), in a state where a boat to which the electric propulsion machine (2) is attached is moored;
a movement determining unit (53) configured to determine whether the boat has moved; and
a discharge control unit (54) configured to stop discharging from the battery (22) to the motor (4) for diagnosing the battery (22), in a case where the movement determining unit (53) determines that the boat has moved during the battery diagnosis process.

2. The battery diagnostic device (51) according to claim 1, further comprising:
a boat movement control unit (82) configured to control the motor (4) to move the boat to a position at start of the battery diagnosis process and maintain the boat at the position, after the discharge control unit stops (54) discharging from the battery (22) to the motor (4) for diagnosing the battery (4).

3. The battery diagnostic device (51) according to claim 1,
wherein the movement determining unit (53) is configured to determine that the boat has moved, in a case where a distance between a current position of the boat and a position of the boat at start of the battery diagnosis process exceeds a predetermined distance.

4. The battery diagnostic device (51) according to claim 1,
wherein the movement determining unit is configured to determine that the boat has moved, in a case where a speed of the boat exceeds a predetermined speed.

5. The battery diagnostic device according to claim 1,
wherein the movement determining unit is configured to determine that the boat has moved, in a case where an acceleration of the boat exceeds a predetermined acceleration.

6. The battery diagnostic device according to claim 1, further comprising a notification unit configured to notify movement of the boat during the battery diagnosis process.

7. A ship propulsion system for propelling a boat, the ship propulsion system comprising:
an electric propulsion machine (2) that is attached to the boat and that includes a motor for driving a propeller (3);
a battery (22) configured to supply electric power to the motor; and
a battery diagnostic device (51) for the electric propulsion machine (2) configured to diagnoses the battery (22),
wherein the battery diagnostic device (51) includes:
a battery diagnostic processing unit (52) configured to perform a battery diagnosis process of diagnosing the battery (22) by discharging from the battery (22) to the motor (4) while the boat is moored;
a movement determining unit (53) configured to determine whether the boat has moved; and
a discharge control unit (54) configured to stop discharging from the battery (22) to the motor (4) for diagnosing the battery (22), in a case where the movement determining unit (53) determines that the boat has moved during the battery diagnosis process.
